# EUROPEAN PATENT APPLICATION

(11) **EP 1 395 103 A2**
(43) Date of publication of application: **03.03.2004**
(21) Application number: 03405610.1
(22) Date of filing: 21.08.2003
(51) Int. Cl.: H05K 7/20, H05K 1/02

(54) **PCB Heatsink**

(30) Priority: 27.08.2002 US 229788
(71) Applicant: Delta Energy Systems AG, 3000 Bern 14 (CH)
(72) Inventor: Murphy, Patrick K., Palm Coast, FL 32164 (US)
(74) Representative: Roshardt, Werner Alfred, Dipl.-Phys.

(57) **Abstract**

A heatsink for a printed circuit board (PCB) overlies most or all of the board. It is clamped tightly to the board with its board-facing surface in close proximity to the heat-generating components on the board. A pliant, thermally-conductive dielectric layer is sandwiched between the PCB and the facing surface of the heatsink. Lands at various heights are formed on the heatsink surface facing the PCB to be in good heat-conducting proximity to the surfaces of heat-generating circuit components of various heights on the PCB.

## Description

### Technical Field

This invention relates to a heatsink for a printed circuit board (PCB), and more particularly to a PCB and heatsink combination wherein the heatsink extends across a plurality of heat generating components in heat conducting relation thereto.

### Background Art

With the reduction in size of many electronic devices, printed circuit boards have become more and more densely populated with components. Many of these components are heat generating so that removing heat from the vicinity of the board has become increasingly important.

Multi-layer boards and, in particular, multi-layer power circuit boards such as power supplies, AC to DC converters, DC to DC converters and the like now employ windings buried among the board's layers and heat generating magnetic cores that penetrate the board from one exterior surface to another. These are closely spaced from the electronic circuit components on one or both of the exterior faces of the board.

In the past, heatsinks for various components, including integrated circuits such as processors, have been provided and these have been attached to the components in various ways, including by clamps. However, these have not served to remove heat from multiple, densely packed circuit elements on a printed circuit board. There remains, therefore, the need to relieve the heat buildup that a densely populated printed circuit board can experience.

### Summary of the invention

In accordance with the present invention, there is provided a heatsink for a PCB that overlies a plurality of heat generating components on one face of the PCB so as to conduct heat away from those components as well as away from the face of the board. As used herein, "heat-generating components on the face of the PCB or board" means electronic components and other circuit elements mounted on the board and magnetics extending or protruding through the board to the board face. In particular, in accordance with one embodiment of the invention, the heatsink overlying a plurality of elements overlies a relatively large portion of the surface area of the board and is affixed to the board. A pliant, thermally conductive, but dielectric layer electrically insulates the heatsink from the components and conductive traces on the board surface while assuring good heat conduction away from the components to the heatsink.

In one particular embodiment, the heatsink is clamped to the board by resilient clamps at aligned edges of the heatsink and board. In that embodiment the pliant dielectric layer is sandwiched between the heatsink and the board surface that carries the components from which heat is conducted.

The heatsink surface facing the board is molded to, at least partly, fit in close proximity on and around heat generating components. In one particular embodiment, the PCB is a multi-layer PCB. In an embodiment in which the PCB is a power component such as a power supply, AC to DC converter, or the like, the heatsink closely overlies magnetic cores that penetrate the board from one face to the other.

Preferably, the heatsink is co-extensive with the PCB to form a combined PCB and heatsink package having the same footprint as the PCB. At its edges, the PCB may have projecting dependent walls that contact the surface of the PCB, partially enclosing the PCB components and the pliant heat-conductive dielectric layer.

In one embodiment, the exterior surface of the heatsink facing away from the PCB is planar and in another embodiment that surface has surface area-increasing features to improve heat dissipation.

The above and further objects and advantages of the invention will be better understood in view of the following detailed description of at least one preferred embodiment taken in consideration with the accompanying drawings.

### Brief description of the drawings

The drawings used to explain the embodiments show:
- Fig. 1: is a perspective view of a multi-layer PCB of the kind to which the heatsink of this invention is applied;
- Fig. 2: is a top perspective view of the PCB of Fig. 1 with the heatsink of the present invention in place;
- Fig. 3: is a bottom perspective view of the PCB of Fig. 1 with the heatsink applied and shows the face of the PCB opposite the heatsink;
- Fig. 4: is an end view of the PCB of Fig. 1 with the heatsink in place;
- Fig. 5: is a further end view, partially in section, showing the PCB of Fig. 1 and the cooperation of the undersurface of the heatsink with the heat generating components of the PCB;
- Fig. 6: is a side view of the PCB of Fig. 1 with the heatsink in place and the PCB electrically connected to and mounted upon a further PCB;
- Fig. 7: is an exploded view of a PCB like that of Fig. 1, and a further embodiment of the heatsink in accordance with the invention, having surface area-increasing features defined on the surface opposite the PCB; and
- Fig. 8: is a further perspective view of an alternative heatsink in accordance with the invention and more clearly shows surface area-increasing features formed on the outward-facing surface of the heatsink.

### Preferred embodiments

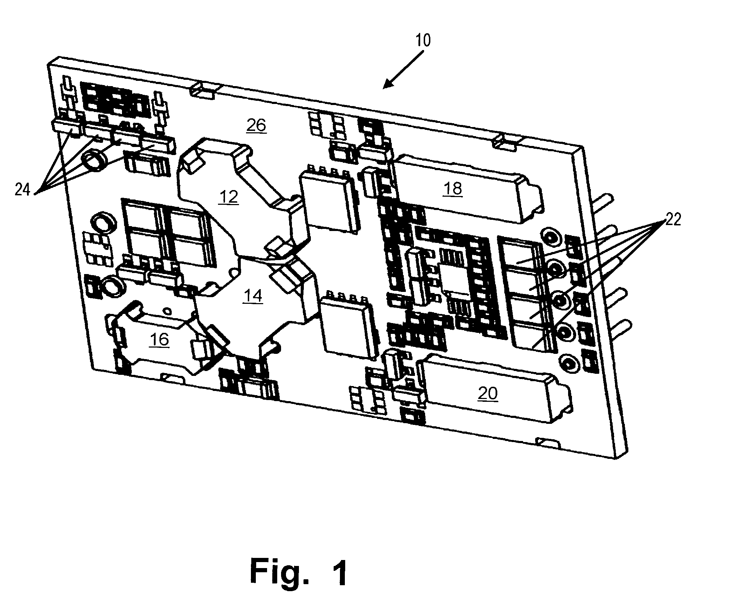

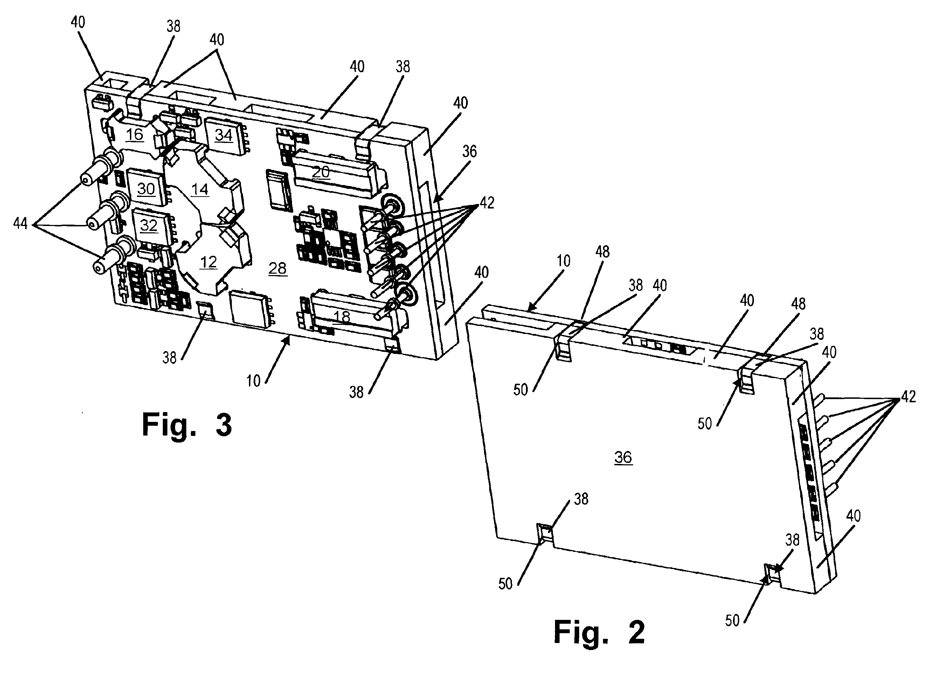

Turning to Fig. 1, there is shown a multi-layer PCB 10 carrying a power supply circuit. Magnetics of the power supply circuit include magnetic cores 12, 14, 16, 18 and 20 penetrating the board. Various electronic components 22 and 24, etc. are mounted on the surface 26 of the board 10. Not shown in Fig. 1, buried windings encircle the penetrating legs of the magnetics 12, 14, 16, 18 and 20. These are carried on interior faces of the one or more layers that make up the board 10. To meet the power density requirements of, for example, today's telecommunications devices, portable computers, PDAs, etc., the board 10 is densely packed with the magnetics and the components on both faces of the board. The face 28 opposite the face 26 of the board is best seen in Fig. 3. There the magnetic cores 12, 14, 16, 18 and 20 are seen where they have emerged from the board and extend generally parallel to the surface 28. Additional components 30, 32, 34, etc. are seen mounted on this face of the board.

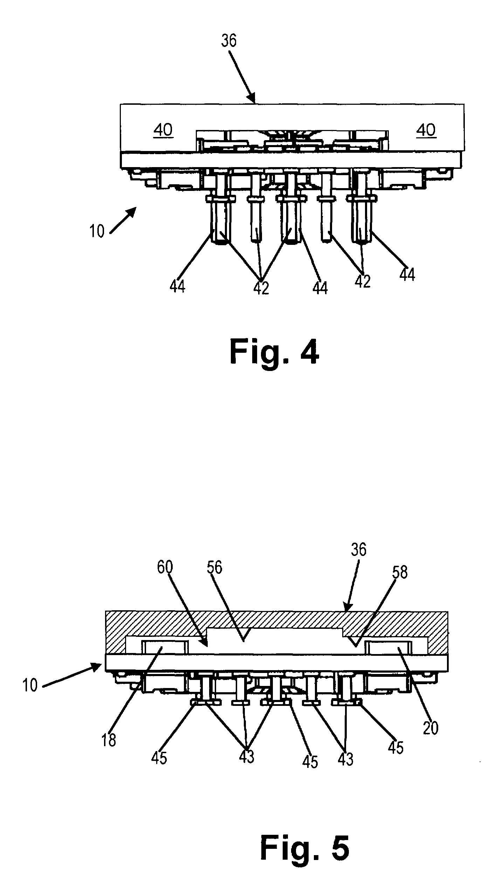

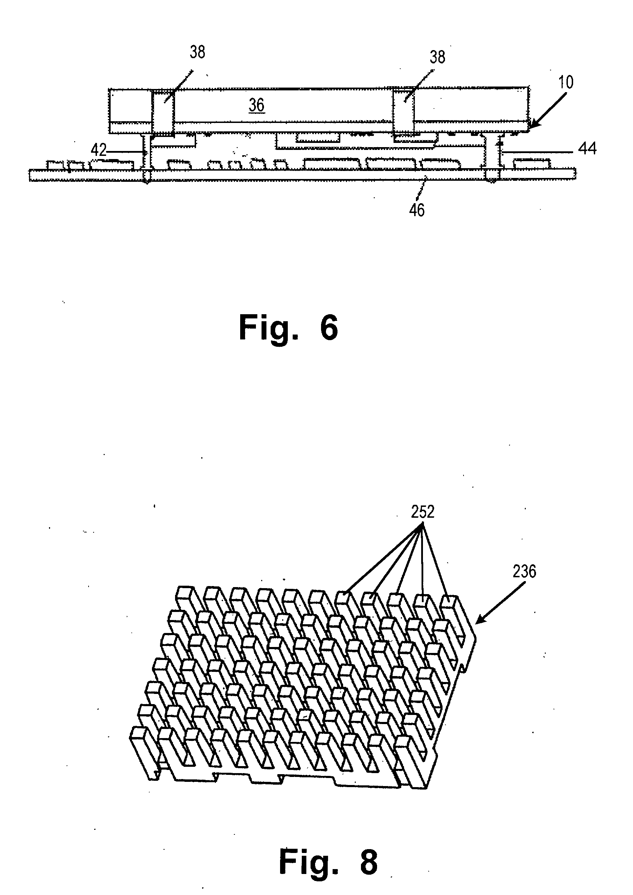

As illustrated in Figs. 2 and 3, a large plate-like heatsink 36 is affixed to the PCB 10 by four resilient metal clips 38. The clips 38 are generally U-shaped and are dimensioned to hold the heatsink tightly to the board. The heatsink 36 is generally coextensive with the board 10 and extends generally parallel to the surface of the board 10. The board 10 and the heatsink 36 can have aligned recesses 48 and 50 that receive the clamps 38. As seen in Fig. 2, 3 and 4, projecting edge portions 40 of the heatsink 36 engage the board 10 along its edges supporting the heatsink and partially enclosing the circuit elements of the face 26 of the board. Best shown in Fig. 3, electrical signal-conducting pins 42 and electrical power pins 44 extend from the surface 28 of the board 10. These connect the board to a circuit board 46 as shown in Fig. 6. The pins 44 supply electrical power to a circuit carried on the board 46. The pins 42 carry electrical control signals and, as can be seen in Fig. 6, the pins 44 and 42 support the board 10 and its associated heatsink 36 above the further PCB 46. As seen in Fig. 5, the signal and power pins that support the board and make electrical connection to the further PCB can be surface-mounting pins like the pins 43 and 45.

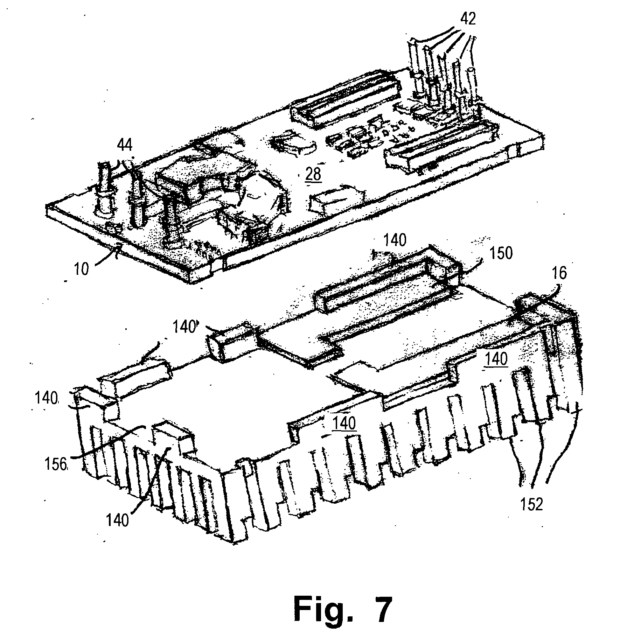

Fig. 7 illustrates an alternative embodiment of the heatsink of this invention in which a series of surface features 152 formed across the face of the heatsink 136 enhance heat dissipation. Fig. 8 better illustrates an alternative arrangement of surface area-increasing features 252 formed on the exterior surface of yet another alternative embodiment of a heatsink 236 in accordance with the invention.

As best seen in Figs. 5 and 7, each embodiment of the heatsink of the invention has on its surface facing the PCB with which it cooperates a series of raised and lowered lands. These are surface areas 56 and 58 in the embodiment of Fig. 5, and 156, 158 and 160 in the embodiment of Fig. 7. The contouring of this surface in this fashion tailors the surface to the particular circuitry carried by the PC board for which it is adapted. For example, the land 56 is at a level where it closely conforms to the height of the magnetics 12, 14 and 16 on the face 28 of the board 10. A portion of the surface projecting outward further from the body of the heatsink 36 forms the land 58 which come closely proximate the elements 18 and 20, elements that extend away from the surface 26 of the board 10 to a lesser extent than the magnetics 12, 14 and 16. In this way the heatsink 36 is in closer proximity to the main heat-generating elements of the PCB 10.

In each of the embodiments of the present invention, a pliant, rubber-like, electrically-insulating but thermally-conductive layer 60 is placed between the elements of the PCB facing the heatsink and the interior heatsink surfaces 56 and 58. The pliant sheet 60 may be a commercially available material such as one of the Gap Pad products available from The Bergquist Company, Chanhassan, MN 55317. The clips 38 hold the heatsink and thermally conductive layer tightly against the heat-generating elements on the board.

It will be seen, then, that by arranging a heatsink that extends over most or all of the heat-generating elements on a PCB's surface, by conforming the heatsink's interior or undersurface to the circuit for which it is designed, and by sandwiching a heat-conductive dielectric between the heatsink and the PCB, good heat transmission of heat away from the heat-generating, densely-packed elements of a PCB is achieved to dissipate such heat to atmosphere.

Although preferred embodiments of the invention have been described in detail, it will be readily appreciated by those skilled in the art that further modifications, alterations and additions to the invention embodiments disclosed may be made without departure from the spirit and scope of the invention as set forth in the appended claims.

## Claims

1. A multilayer printed circuit board and heatsink combination comprising:
a) a multilayer printed circuit board having heat generating components on at least one face thereof,
b) a heatsink overlying the at least one face of the board and the heat-generating components thereon,
c) the heatsink having a surface conforming in part in contour to the heat-generating components on the board so as to fit on and around these components,
d) a heat conducting dielectric layer sandwiched between and in heat-conducting contact with the heatsink and the board and its heat-generating components, and
e) a plurality of connector clips securing the heatsink to the board.

2. The multilayer printed circuit board and heatsink according to claim 1, wherein the heatsink is substantially coextensive with the multilayer printed circuit board.

3. The multilayer printed circuit board and heatsink according to claim 2, wherein the heatsink has a second, exterior surface that is planar across a major portion of its area.

4. The multilayer printed circuit board and heatsink according to claim 2, wherein the heatsink has a second exterior surface of surface area-increasing features.

5. The multilayer printed circuit board and heatsink according to claim 2, wherein the clips are resilient metal clips dimensioned to grasp and hold together the board and the heatsink at their edges.

6. The multilayer printed circuit board and heatsink according to claim 5, wherein the board and the heatsink have aligned recesses into which the clips fit.

7. The multilayer printed circuit board and heatsink according to claim 1, wherein the board has at least one magnetic, the magnetic having a core penetrating multiple layers of the board and having an exterior portion with a surface external of the multiple layers of the board, the heatsink and intermediate dielectric layer being held tightly to the exterior surface of the core in heat conducting relation to the core.

8. The multilayer printed circuit board and heatsink according to claim 7, wherein the board is a power circuit, a plurality of conductive power-supply pins projecting from a second face of the board opposite the at least one face and adapted to connect to a further printed circuit board.

9. The multilayer printed circuit board and heatsink according to claim 8, further comprising a plurality of conductive signal-conducting pins projecting from the second face of the board and adapted to connect to the further printed circuit board.

10. A multilayer printed circuit board and heatsink combination comprising:
a) a multilayer printed circuit board;
b) a power circuit carried on at least one surface of the board;
c) magnetics having cores penetrating the board and buried windings on interior surfaces of layers of the multilayer board;
d) heat-generating electronic components on the at least one surface of the board;
e) a heatsink overlying the cores and the heat-generating electronic components on the at least one surface of the board;
f) a series of lands of varying heights adapted to be closely proximate the cores and heat-generating electronic components upon the heatsink being secured to the board;
g) a thermally conductive, pliant, dielectric layer sandwiched between the board and the heatsink in contact with the cores and the heat-generating electronic components on the at least one surface of the board and the lands on the heatsink; and
h) means for securing the heatsink to the board.

11. The multilayer printed circuit board and heatsink combination of claim 10, wherein the means for securing the heatsink to the board comprises a plurality of resilient metal clamps engaging the board and the heatsink at edges thereof.

12. A heatsink for a printed circuit board having heat-generating components mounted on at least one face; the heatsink comprising a plate of heat-conductive material having a first surface contoured to accept into recesses formed therein heat-generating components on the board in heat-conducting association with the heatsink.

13. The heatsink according to claim 12, wherein the plate is substantially the same width and length as the board for which the heatsink is intended to be used.

14. The heatsink according to claim 13, wherein the heatsink has edge portions protruding from the first surface to engage the board at edges thereof, at least partially enclosing the components on the at least one face of the board.

15. The heatsink according to claim 13, wherein the plate has a substantially flat second surface.

16. The heatsink according to claim 13, wherein the plate has a second surface with surface area-increasing protrusions formed thereon.

17. The heatsink according to claim 13, wherein the plate has clamp-receiving recesses formed at edges thereof to receive clamps clamping the plate to the board.

18. The heatsink according to claim 14, wherein at least a plurality of areas on the first surface located for alignment with heat-generating components on the board have variations in height that bring them closely proximate to surfaces of the heat-generating components when the heatsink is secured to the board.
